# EUROPÄISCHE PATENTSCHRIFT

(11) **EP 1 673 637 B1**
(45) Veröffentlichungstag und Bekanntmachung des Hinweises auf die Patenterteilung: **14.02.2007**
(21) Anmeldenummer: 04765316.7
(22) Anmeldetag: 16.09.2004
(51) Int. Cl.: G01R 31/26

(54) **SCHALTERVORRICHTUNG**
SWITCH DEVICE
SYSTEME A COMMUTATEUR

(30) Priorität: 04.11.2003 DE 10351387
(43) Veröffentlichungstag der Anmeldung: 28.06.2006
(73) Patentinhaber: Fraunhofer-Gesellschaft zur Förderung der angewandten Forschung e.V., 80686 München (DE)
(72) Erfinder: HACKNER, Michael, 92331 Parsberg (DE)
(74) Vertreter: Zinkler, Franz
(86) Internationale Anmeldenummer: PCT/EP2004/010417
(87) Internationale Veröffentlichungsnummer: WO 2005/052610

(56) Entgegenhaltungen:
- JP-A- 50 030 481
- US-A- 4 851 769
- PATENT ABSTRACTS OF JAPAN Bd. 0040, Nr. 27 (P-001), 7. März 1980 (1980-03-07) & JP 55 002918 A (HITACHI LTD), 10. Januar 1980 (1980-01-10)
- LOCCI N ET AL: "MEASUREMENT OF INSTANTANEOUS LOSSES IN SWITCHING POWER DEVICES" IEEE TRANSACTIONS ON INSTRUMENTATION AND MEASUREMENT, IEEE INC. NEW YORK, US, Bd. 37, Nr. 4, Dezember 1988 (1988-12), Seiten 541-546, XP002046786 ISSN: 0018-9456
- "SIMPLE TRANSISTOR TESTER" ELEKTOR ELECTRONICS, ELEKTOR PUBLISHERS LTD. CANTERBURY, GB, Bd. 21, Nr. 239, 1. Dezember 1995 (1995-12-01), Seite 62, XP000549022 ISSN: 0268-4519
- BLASCHKE R: "SMART TRANSISTOR TESTER" ELEKTOR ELECTRONICS, ELEKTOR PUBLISHERS LTD. CANTERBURY, GB, Bd. 21, Nr. 239, 1. Dezember 1995 (1995-12-01), Seiten 24-29, XP000549001 ISSN: 0268-4519

## Beschreibung

Die vorliegende Erfindung betrifft eine Schaltervorrichtung und insbesondere eine Schaltervorrichtung mit einer Testmöglichkeit zum Testen der Funktionsfähigkeit eines elektronischen Schalters.

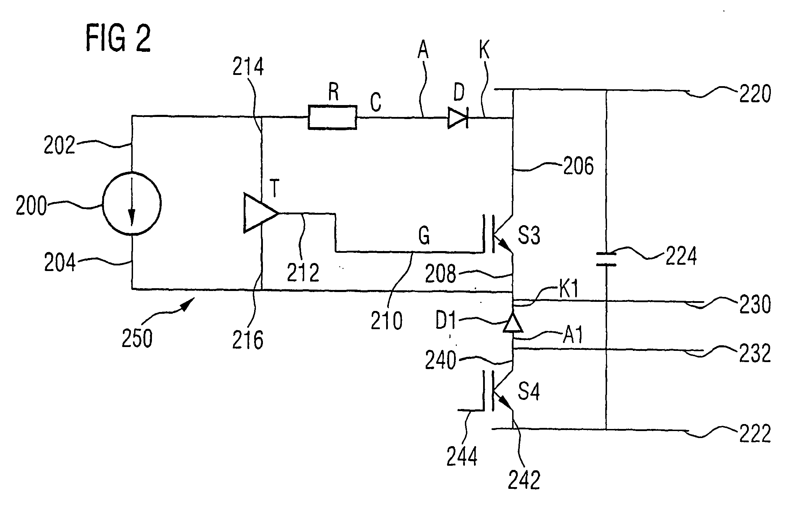

In Schutzschaltungen werden vielfach alle Komponenten, die Leistung schalten (Schalter), einem Funktionstest unterzogen, bevor sie aktiviert werden. Durch einen solchen Funktionstest lassen sich Fehler erkennen, die beim Betrieb der Schaltung zu einer schweren Schädigung bzw. einer Zerstörung der Komponenten der Schaltung führen. In Fig. 2 ist eine derartige konventionelle Schaltung (beispielsweise eine Umschaltschaltung oder ein Umrichter) mit Überstrom-Erkennung dargestellt. Die Schaltung gemäß Fig. 2 umfaßt eine Spannungsquelle 200 mit einem ersten Anschluß 202 und einem zweiten Anschluß 204. Ferner umfaßt die Schaltung einen Widerstand R und eine Diode D, wobei die Diode D eine Kathode K und eine Anode A aufweist. Der Widerstand R ist zwischen die Anode A und den ersten Anschluß 202 der Spannungsquelle 200 geschaltet. Ferner weist die Schaltung einen zu testenden Schalter S3 mit einem ersten Anschluß 206 und einem zweiten Anschluß 208 sowie einen Steueranschluß 210 auf. Der erste Anschluß 206 des zu testenden Schalters S3 ist leitfähig mit der Kathode K verbunden. Der zweite Anschluß 208 des zu testenden Schalters S3 ist leitfähig mit dem zweiten Anschluß 204 der Spannungsquelle 200 verbunden. Der Steueranschluß 210 des Schalters S3 ist leitfähig mit einem Steuerausgang 212 einer Treiberschaltung T verbunden, wobei die Treiberschaltung T ferner einen ersten Anschluß 214, der mit dem ersten Anschluß 202 der Spannungsquelle 200 verbunden ist und einen zweiten Anschluß 216 aufweist, der mit dem zweiten Anschluß 204 der Spannungsquelle 200 verbunden ist. Die Schaltung gemäß Fig. 2 weist ferner einen Eingang mit einem ersten Eingangsanschluß 220 und einem zweiten. Eingangsanschluß 222 auf. Zwischen den ersten Eingangsanschluß 220 und den zweiten Eingangsanschluß 222 kann ein Kondensator 224 geschaltet sein. Ferner weist die Schaltung einen Ausgang mit einem ersten Ausgangsanschluß 230 und einem zweiten Ausgangsanschluß 232 auf. Zwischen den ersten Ausgangsanschluß 230 und den zweiten Ausgangsanschluß 232 kann, wie in Fig. 2 dargestellt, eine weitere Diode D1 mit einer weiteren Kathode K1 und einer weiteren Anode A1 geschaltet sein, wobei die weitere Kathode K1 leitfähig mit dem ersten Ausgangsanschluß 230 und die weitere Anode A1 leitfähig mit dem zweiten Ausgangsanschluß 232 verbunden ist. Ferner ist der erste Eingangsanschluß 220 leitfähig mit dem ersten Anschluß 206 des zu testenden Schalters S3 verbunden. Der zweite Anschluß 208 des zu testenden Schalters S3 ist leitfähig mit dem ersten Ausgangsanschluß 230 verbunden. Der zweite Ausgangsanschluß 232 ist leitfähig mit einem ersten Anschluß 240 eines weiteren Schalters S4 leitfähig verbunden, während der zweite Eingangsanschluß 222 leitfähig mit einem zweiten Anschluß 242 des weiteren Schalters S4 verbunden ist, wobei der weitere Schalter S4 zusätzlich einen Steueranschluß 244 umfaßt. Durch die Komponenten der Spannungsquelle 200, der Treiberschaltung T, dem Widerstand R, der Diode D und dem zu testenden Schalter S3 ist ferner eine Schaltervorrichtung 250 ausgebildet.

Für eine derart verschaltete Schaltervorrichtung 250 bestehen mehrere Möglichkeiten zur Überwachung der Funktionsfähigkeit der Schaltung bzw. zur Überwachung der Funktionsfähigkeit des Schalters S3. Wird beispielsweise ein IGBT (IGBT = isolated-gate-bipolar-transistor) als zu testender Schalter S3 verwendet, dann stehen als überwachbare Signale bei dem Funktionstest der Schaltung (d. h. bei Anlegen einer Spannung durch die Spannungsquelle 200) als überwachbare Signale die Gate-Emitter-Spannung (Spannung zwischen dem Steueranschluß 210 des Schalters S3 (Messpunkt G) und dem zweiten Anschluß 204 der Spannungsquelle 200) und die Kollektor-Sense-Spannung (Spannung zwischen der Anode A der Diode D (Messpunkt C) und dem zweiten Anschluß 204 der Spannungsquelle 200) zur Verfügung. Wird das Gate (d. h. der Steueranschluß 210 des zu testenden Schalters S3) mit 0 V bezüglich des Emitters 208 angesteuert, dann sperrt der funktionsfähige IGBT und an der Anode A liegt die maximale Spannung (d.h. die Betriebsspannung der Treiberschaltung T bzw. die maximale Spannung der Spannungsquelle 200 von beispielsweise 15 V) an. Wird der IGBT über die Treiberschaltung eingeschaltet (d.h. es fallen beispielsweise 15 V an der Gate-Emitter-Strecke ab), dann leitet die Kollektor-Emitter-Strecke und die am Messpunkt C abgreifbare der Spannung zwischen der Anode A der Diode D und dem zweiten Anschluß 204 der Spannungsquelle 200 wird geringer, was beispielsweise durch eine In-Betrieb-Prüfeinrichtung detektierbar ist. Alternativ kann die In-Betrieb-Prüfeinrichtung auch ein Potential des ersten Anschlusses 206 des zu testenden Schalters S3 überwachen. In Umrichtern läßt sich durch Überwachung des Meßpunktes C im eingeschalteten Zustand ein zu hoher Kollektor-Emitter-Strom erkennen. Durch Abschaltung des Umrichters kann in diesem Fall eine thermische Zerstörung des IGBTs verhindert werden.

Nachteilhaft erweist sich jedoch, daß sich durch diese Diagnose zwar einige Fehler erkennen lassen (z. B. ein Leerlauf in der Kollektor-Emitter-Strecke), aber nicht alle auftretenden Fehler. Beispielsweise kann ein Kurzschluß zwischen Gate und Emitter nicht sicher erkannt werden. Nur wenn der Kurzschluß deutlich niederohmiger als der Gate-Treiber ist, ist dieser Fehler detektierbar.

Die JP-A-50030481 zeigt einen Transistor, dessen Kollektor über einen Widerstand mit einer Versorgungsspannungsquelle verbunden ist und dessen Emitter mit einem Massepotential verbunden ist. Ferner ist der Kollektor des zu testenden Transistors mit einem Kollektor eines weiteren Schalttransistors und der Emitter des weiteren Schalttransistors mit der Basis des zu testenden Transistors verbunden. Ferner ist der Kollektor des zu testenden Transistors über einen weiteren Widerstand mit einem dritten Transistor verbunden, der mit einem Eingang eines Flip-Flops verbunden ist, so dass mittels des Flip-Flops eine Spannung zwischen dem Kollektor des zu testenden Transistors und dem Emitter des zu testenden Transistors detektierbar ist.

Die JP-A-55002918 zeigt ein Gerät zum Erkennen einer negativen Widerstandswellenform eines Halbleiterbauelements. Um zu überprüfen, ob ein Halbleiterbauelement defekt ist und eine negative Widerstandscharakteristik hat. Hierbei werden Spannung und Strom, die durch eine Quelle eines zu überprüfenden Transistors eingeprägt werden, detektiert und sampleweise mittels Verstärkern in Halteschaltkreise eingespeichert. Weiterhin werden sie durch A/D-Wandler in digitale Daten konvertiert. A/D-gewandelte Werte werden in einen Speicher eingegeben und als charakteristische Wellenform des Transistors gespeichert. Durch einen Speicherausleseschaltkreis werden sie für jede Koordinate derart ausgelesen, dass jeder Spannungswert angezeigt wird. Ein Diskriminator zählt die Anzahl von Koordinaten, die zwei oder mehr Werte "Null" oder "Eins" haben und bestimmt, ob die Anzahl solcher Koordinaten eine vorgesetzte Referenzanzahl überschreitet oder nicht.

Die wissenschaftliche Veröffentlichung "Measurement of Instantaneous Losses in Switching Power Decives", publiziert von Locci et al. in IEEE Transactions on Instrumentation and Measurement, 37, 1988 (DEC), Nr. 4, New York, NY, USA, offenbart eine Technik zum Messen von unmittelbaren Leistungsverlusten in elektronischen Leistungsschaltelementen. Die Schwierigkeiten beim Messen von Strom und Spannung, die großteils während des Schaltens variieren, beeinflussen üblicherweise die Ergebnisse, wodurch große Fehler entstehen. Die dieser Veröffentlichung zugrunde liegende Aufgabe besteht darin, mit einem ausreichenden Grad von Genauigkeit die augenblickliche Leistung im Hinblick auf eine Charakterisierung der Verluste in den verschiedenen Intervallen von einem Schaltungszyklus zu messen (Einschaltverzögerung, Steigzeit, Ein-Zustand, Ausschaltverzögerung, Fallzeit, Aus-Zustand). Hierzu wird ein System zum Messen von Spannungen und Strömen eingesetzt, das auf einer Abtastung mit 200 Megasamples pro Sekunde zur Datenakquisition basiert. Diese Daten werden dann zu einem Personalcomputer (PC) transferiert, dann konditioniert und verarbeitet, um die Augenblickswerte und die Mittelwerte für Leistungsverluste für jeden Arbeitszyklus oder Einzelimpuls zu erhalten.

Der Artikel "Simple Transistor Tester" von Canterbury, der in der Zeitschrift Elektor Electronics, 21 (1995, Dezember, Nr. 239, Dorchester, GB) veröffentlicht ist, zeigt einen Tester, der überprüft, ob ein Transistor (sowohl n-p-n als auch p-n-p) arbeitet oder nicht. Wenn er arbeitet, emitiert ein Summer ein Quäken. Hierbei bilden zwei Transistoren einen astabilen Multivibrator, der bei einer Frequenz um 1 kHz oszilliert. Der zu testende Transistor ist über K₁ an den Oszillator angeschlossen. Wenn der Oszillator arbeitet, was bedeutet, dass der zu testende Transistor arbeitet, erscheint eine Rechteckspannung über dem Element P₁, welche den Summer BZ₁ anregt. Die Lautstärke von dem imitierten Ton kann durch eine Vorregelstufe, wie gewünscht, angepasst werden.

Die US-A-4,851,769 zeigt einen nicht-zerstörenden Tester für Transistoren. Die US-A-9,851,769 zeigt hierbei einen nicht-zerstörenden rückwärts-vorgespannten zweiten Durchbruchtester zum Testen von Halbleiterbauelementen wie Transistoren und Tyrestoren, die eine Basis-Kollektor-Emitterkonfiguration haben. Grundlegend umfasst der Tester einen Aufnahmesockel zum Halten des zu testenden Gerätes. Ein Basistreiber liefert einen Treiberstrom zu der Basis des zu testenden Gerätes. Eine Kollektorversorgung liefert einen Kollektorstrom zu dem zu testenden Gerät. Ein Stromnebenschlussdämpfungswiderstand lenkt Strom von dem zu testenden Gerät weg, wenn das zu testenden Gerät einen rückwärts-vorgespannten zweiten Durchbruch erleidet. Der Nebenschlussdämpfungswiderstand umfasst erste, zweite und dritte Schalter, die in Serie angeordnet sind. Ein Diodennebenschlussdämpfungswiderstand ist zu der Stromversorgung und dem dritten Schalter geschaltet. Ein Detektor produziert ein erstes Signal beim Einsetzen des rückwärts-vorgespannten zweiten Durchbruchs in dem zu testenden Gerät. Ansprechend auf das erste Signal werden nacheinander der erste, zweite und dritte Schalter aktiviert. Die Aktivierung von allen der ersten, zweiten und dritten Schalter verursacht den Strom der dem besagten zu testenden Gerät durch den besagten Diodennebenschlussdämpfungswiderstand und den ersten, zweiten und dritten Schalter abgetrennt wird.

Der vorliegenden Erfindung liegt daher die Aufgabe zugrunde, eine Schaltervorrichtung bereitzustellen, in die eine verbesserte Möglichkeit zum Erkennen von Fehlern eines zu testenden Schalters bietet, und somit eine höhere Betriebssicherheit und eine gesteigerte Verfügbarkeit der Schaltervorrichtung bietet.

Diese Aufgabe wird durch eine Schaltervorrichtung gemäß Anspruch 1 gelöst.

Die vorliegende Erfindung schafft eine Schaltervorrichtung mit den folgenden Merkmalen:
einen zu testenden Schalter mit einem ersten und einem zweiten Anschluß sowie einem Steueranschluß zum Steuern eines Widerstandes zwischen dem ersten und dem zweiten Anschluß;
einem Widerstand;
einer Einrichtung zum Bereitstellen eines Meßstroms über den Widerstand in den ersten Anschluß des Schalters, wobei der Steueranschluß und der erste Anschluß des Schalters elektrisch leitfähig gekoppelt sind; und
einer Einrichtung zum Erfassen einer aufgrund des Meßstroms vorhandenen Spannung zwischen dem Steueranschluß und dem zweiten Anschluß des Schalters, wobei die Spannung auf eine Funktionsfähigkeit des Schalters hinweist.

Erfindungsgemäß wird der oben beschriebenen Ansatz verlassen, bei dem ein Überwachen des Widerstandes zwischen dem ersten und dem zweiten Anschluß des zu testenden Schalters durch ein alleiniges Beaufschlagen des Steueranschlusses des zu testenden Schalters mit einer Spannung der Treiberschaltung erfolgt. Erfindungsgemäß ist der Steueranschluß und der erste Anschluß des zu testenden Schalters elektrisch leitfähig gekoppelt. Für eine elektrisch leitfähige Kopplung zwischen dem Steueranschluß des zu testenden Schalters und dem ersten Anschluß des zu testenden Schalters wird hierbei vorzugsweise ein zweiter Schalter eingesetzt, wobei das Koppeln des Steueranschlußes mit dem ersten Anschluß des zu testenden Schalters durch das Schließen des zweiten Schalters erfolgt. Ferner wird vorzugsweise eine elektrisch leitfähige Verbindung zwischen dem Steuerausgang der oben beschriebenen Treiberschaltung und dem Steueranschluß des zu testenden Schalters beispielsweise durch einen geöffneten dritten Schalter getrennt. Der zweite Schalter und der dritte Schalter lassen sich in einen ersten und einen zweiten Betriebsmodus schalten, wobei im ersten Betriebsmodus der zweite Schalter geöffnet und der dritte Schalter geschlossen sowie im zweiten Betriebsmodus der zweite Schalter geschlossen und der dritte Schalter geöffnet ist.

Durch eine derartige Verschaltung ist es möglich, im ersten Betriebsmodus die Funktionsfähigkeit des zu testenden Schalters wie in einer oben beschriebenen Schaltervorrichtung zu überprüfen. Zugleich bietet die vorliegende Erfindung zusätzlich die Möglichkeit, durch ein Umschalten auf den zweiten Betriebsmodus weitere Fehler des zu testenden Schalters (beispielsweise einen Kurzschluß zwischen dem Steueranschluß und dem zweiten Anschluß des zu testenden Schalters) zu entdecken, die durch eine oben beschriebene Schaltervorrichtung nicht detektierbar sind.

Die vorliegende Erfindung bietet somit den Vorteil, einen zu testenden Schalter vollständig auf seine Funktionsfähigkeit testen zu können. Alle denkbaren Fehler lassen sich durch die vorliegende Erfindung bereits vor einer Inbetriebnahme des zu testenden Schalters entdecken. Es ist somit nicht notwendig, den Versagensfall während dem Betrieb des zu testenden Schalters bei der Schaltung von hohen Leistungen abzuwarten, bei dem gegebenenfalls größere Schäden entstehen könnten. Somit ist eine höhere Betriebssicherheit und eine gesteigerte Verfügbarkeit der Schaltung zu erwarten. Ferner weist die vorliegende Erfindung den Vorteil auf, daß die Abänderung einer herkömmlichen Schaltung zum Testen der Funktionalität lediglich durch einfache schaltungstechnische Maßnahmen, insbesondere durch die Verwendung von zwei zusätzlichen Schalterelementen realisierbar ist. Die Möglichkeit zur Erkennung von weiteren Fehlern erfordert somit lediglich einen geringen Zusatzaufwand.

Ein bevorzugtes Ausführungsbeispiel der vorliegenden Erfindung ist nachfolgend anhand der beiliegenden Zeichnungen näher erläutert. Es zeigen:
- Fig. 1: eine Schaltungstopologie einer Ansteuerung, die eine Schaltervorrichtung gemäß einem bevorzugten Ausführungsbeispiel der vorliegenden Erfindung umfaßt; und
- Fig. 2: eine Schaltungstopologie einer Ansteuerung, die eine herkömmliche Schaltervorrichtung umfaßt.

In der nachfolgenden Beschreibung des bevorzugten Ausführungsbeispiels der vorliegenden Erfindung werden für die in den verschiedenen Zeichnungen dargestellten und ähnlich wirkenden Elemente gleiche Bezugszeichen verwendet.

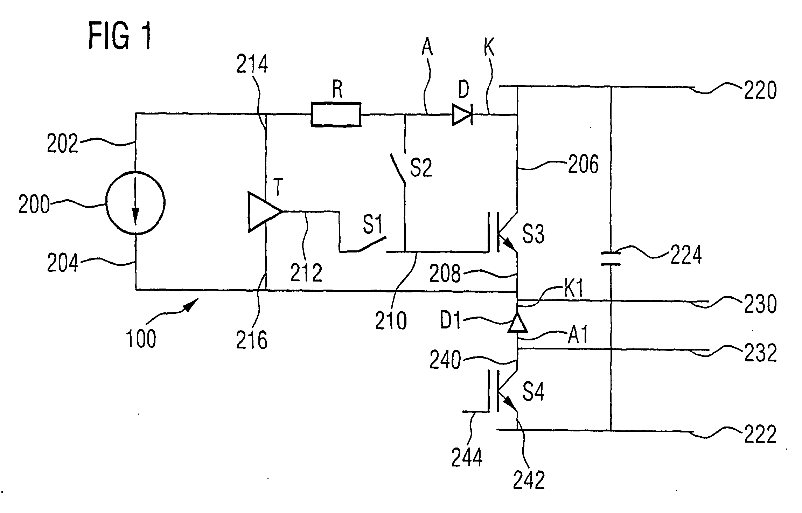

In Fig. 1 ist die Schaltungstopologie einer Ansteuerung (Umschaltschaltung) unter Verwendung eines bevorzugten Ausführungsbeispiels einer erfindungsgemäßen Schaltervorrichtung 100 dargestellt. Die Schaltungstopologie des bevorzugten Ausführungsbeispiels der erfindungsgemäßen Schaltervorrichtung 100 entspricht im wesentlichen der in Fig. 2 gezeigten Schaltervorrichtung 250. Im Unterschied zu der in Fig. 2 gezeigten Schaltervorrichtung 250 weist die in Fig. 1 dargestellte Schaltervorrichtung 100 einen zweiten Schalter S2 auf, der zwischen die Anode A der Diode D und den Steueranschluß 210 des zu testenden Schalters S3 geschaltet ist. Ferner weist die Schaltervorrichtung 100 einen dritten Schalter S1 auf, der zwischen den Steuerausgang 212 der Treiberschaltung T und den Steueranschluß 210 des zu testenden Schalters S3 geschaltet ist. Der zweite Schalter S2 und der dritte Schalter S1 lassen sich jeweils in einen geschlossenen und einen geöffneten Zustand schalten. Durch eine in Fig. 1 nicht dargestellte Schaltersteuereinrichtung lassen sich der zweite Schalter S2 und der dritte Schalter S1 in einen ersten Betriebsmodus und einen zweiten Betriebsmodus schalten, wobei im ersten Betriebsmodus der zweite Schalter S2 geöffnet und der dritte Schalter S1 geschlossen ist sowie im zweiten Betriebsmodus der zweite Schalter S2 geschlossen und der dritte Schalter S1 geöffnet ist. Die Schaltersteuereinrichtung ist ferner ausgebildet, in dem ersten Betriebsmodus zu sein, wenn der zu testende Schalter S3 im Normalbetrieb ist und um in dem zweiten Betriebsmodus zu sein, wenn der zu testenden Schalter in einem Testbetrieb ist. Der Testbetrieb ist hierbei dadurch charakterisiert, daß zwischen dem ersten Eingangsanschluß 220 und dem zweiten Eingangsanschluß 222 der Umschaltschaltung keine Spannung anliegt. Wird beispielsweise für den zu testenden Schalter S3 ein IGBT mit einem Kollektor als ersten Anschluß 206, einem Emitter als zweiten Anschluß 208 und einem Gate als Steueranschluß 210 verwendet, läßt sich im Normalbetrieb durch die von der Spannungsquelle 200 bereitgestellte Spannung (beispielsweise 15 V) die Funktionsfähigkeit des IGBT S3 in Bezug auf die Kollektor-Emitter-Strecke testen. Wird beispielsweise durch die Treiberschaltung T am Steueranschluß 210 des zu testenden IGBT S3 eine Spannung angelegt, durch die der IGBT gesperrt ist, fließt zwischen dem Kollektor 206 und dem Emitter 208 kein Strom, wodurch keine Spannung am Widerstand R abfällt und somit am Meßpunkt C die maximale Spannung der Spannungsquelle 200 von beispielsweise 15 V anliegt. Wird durch den Treiber am Steueranschluß 210 des IGBT S3 (d. h. dem Gate des IGBT S3) eine Spannung angelegt, durch die der IGBT S3 durchgeschaltet wird, fließt zwischen dem Kollektor 206 und dem Emitter 208 ein Strom (Meßstrom). Der durch die Spannung der Spannungsquelle 200 verursachte Messstrom, der durch den Widerstand R, die Diode D sowie den IGBT S3 fließt, führt zu einem Spannungsabfall am Widerstand R. Hierdurch liegt am Meßpunkt C lediglich eine gegenüber der maximalen Spannung der Spannungsquelle 200 reduzierte Spannung an, die durch eine hier nicht dargestellte Einrichtung zum Erfassen einer aufgrund des Meßstroms vorhandenen Spannung detektierbar ist. Durch ein Auswerten der detektierten Spannung am Meßpunkt C läßt sich somit erkennen, ob der IGBT S3 beispielsweise einen Leerlauf-Fehler in der Kollektor-Emitter-Strecke (kein Absinken der Spannung am Meßpunkt C bei durchgeschaltetem IGBT S3) oder einen Kurzschluß-Fehler in der Kollektor-Emitter-Strecke (Absinken der Spannung am Meßpunkt C bei gesperrtem IGBT S3) erkennen.

Neben dem ersten Betriebsmodus, in dem Fehler des zu testenden IGBT S3 mit der oben beschriebenen herkömmlichen Methode getestet werden können, läßt sich durch die Schaltersteuereinrichtung weiterhin der zweite Betriebsmodus einstellen, wenn der zu testende Schalter S3 im Testbetrieb ist. Hierbei ist der Meßpunkt C leitfähig mit dem Steueranschluß 210 des zu testenden Schalters S3 (d. h. beispielsweise dem Gate eines zu testenden IGBT) verbunden. Wird bei einem geöffneten Zustand aller anderen Schalter (d. h. des dritten Schalters S1 und der weiteren Schaltvorrichtung S4) die erfindungsgemäße Schaltvorrichtung 100 durch die Spannungsquelle 200 mit einer Spannung (beispielsweise 15 V) beaufschlagt, resultiert hierdurch ein über den Widerstand R, die Diode D und dem zu testenden Schalter S3 fließender Meßstrom. Dadurch, daß der Steueranschluß 210 des zu testenden Schalters S3 durch den zweiten Schalter S2 mit der Anode A leitfähig verbunden ist, ist durch eine derartige Verschaltung ein Regelkreis ausgebildet, der sicherstellt, daß sich bei einem funktionsfähigen zu testenden Schalter S3 am Steueranschluß 210 des zu testenden Schalters S3 eine vordefinierte Schwellenspannung einstellt. Ist der zu testenden Schalter S3 beispielsweise ein Transistor (wie z. B. MOS-FET = Metall-Oxid-Semiconductor-Feldeffekttransistor, IGBTs, BipolarTransistoren oder ähnliche) entspricht die vordefinierte Schwellenspannung der entsprechenden Transistor-Schwellenspannung. Bei Vorliegen eines Fehlers zwischen dem Gate 210 und dem Emitter 208 eines zu testenden IGBTs S3 ist die am Meßpunkt G anliegende Spannung geringer als die Transistor-Schwellenspannung des verwendeten IGBTs. Über eine hier nicht dargestellte Einrichtung zum Erfassen einer aufgrund des Meßstroms vorhandenen Spannung zwischen dem Steueranschluß 210 und dem zweiten Anschluß 208 des zu testenden Schalters S3 läßt sich somit die zwischen dem Meßpunkt G und dem zweiten Anschluß 208 des zu testenden Schalters S3 anliegende Spannung detektieren und in Bezug auf einen Fehler in der Gate-Emitter-Strecke interpretieren.

Durch eine derartige Umschaltmöglichkeit zwischen dem ersten und dem zweiten Betriebsmodus läßt sich gegenüber einer herkömmlichen Schaltervorrichtung ein zu testender Schalter S3 im Testbetrieb vollständig testen. Insbesondere läßt sich hierdurch ein Kurzschluß- bzw. Leerlauffehler zwischen dem Kollektor 206 und dem Emitter 208 sowie zusätzlich ein Kurzschluß zwischen dem Gate 210 und dem Emitter 208 erkennen. Der größte detektierbare Kurzschluß-Widerstand wird somit nicht durch den Ausgangs-Widerstand des Gate-Treibers definiert, sondern durch den Widerstand, durch den der Meßpunkt C mit einer Versorgungsspannung des Gate-Treibers (d.h. der Spannung der Spannungsquelle 200) verbunden ist.

Durch einen derartigen vollständigen Funktionstest eines zu testenden IGBT S3 in der in Fig. 1 dargestellten Umschaltschaltung läßt sich somit sicherstellen, daß der als Schalter S3 vorgesehene IGBT voll funktionsfähig ist. Somit lässt sich sicherstellen, dass bei einem Übergang vom Testbetrieb in den Normalbetrieb (d. h. beispielsweise einem Aufschalten einer Gleichspannung zwischen dem ersten Eingangsanschluß 220 und dem zweiten Eingangsanschluß 222 auf den Ausgang) bei einem gleichzeitigen Umschalten vom dem zweiten Betriebsmodus in den ersten Betriebsmodus gewährleistet ist, daß der als Schalter eingesetzte IGBT S3 korrekt funktioniert und ein Versagen der Schaltervorrichtung 100 nicht zu erwarten ist.

Alternativ zu dem dritten Schalter S1, der beispielsweise (wie in Fig. 1 dargestellt) als niederohmiger AnalogSchalter ausgebildet sein kann (beispielsweise als Taster) kann zur Realisierung der Funktion des dritten Schalters auch eine Treiberschaltung mit einem Tri-State-Ausgang verwendet werden. Hierbei ist durch einen weiteren Schalter das durch die Treiberschaltung bereitgestellte Signal dadurch vom Steueranschluß eines zu testenden Schalters zu trennen, daß über den weiteren Schalter der Tri-State-Ausgang der Treiberschaltung inaktiviert (d. h. gegenüber einen niederohmigen aktiven Zustand hochohmig geschaltet) wird.

Obwohl oben ein bevorzugtes Ausführungsbeispiel der vorliegenden Erfindung näher erläutert wurde, ist offensichtlich, daß die vorliegende Erfindung nicht auf dieses Ausführungsbeispiel beschränkt ist. Insbesondere findet die vorliegende Erfindung auch Anwendung auf weitere elektronische Bauelemente mit einem ersten und zweiten Anschluß sowie einem Steueranschluß, wobei insbesondere die Bauelementtypen eines MOS-FETs und eines Bipolar-Transistors zu nennen sind. Weiterhin ist die vorliegende Umschaltschaltung nicht auf die Verwendung lediglich einer einzigen erfindungsgemäßen Schaltervorrichtung beschränkt.

## Patentansprüche

1. Schaltervorrichtung (100) mit folgenden Merkmalen:
einem zu testenden Schalter (S3) mit einem ersten Anschluß (206) und einem zweiten Anschluß (208) sowie einem Steueranschluß (210) zum Steuern eines Widerstandes zwischen dem ersten Anschluß (206) und dem zweiten Anschluß (208);
einem Widerstand (R);
einer Einrichtung zum Bereitstellen eines Meßstroms über den Widerstand (R) in den ersten Anschluß (206) des zu testenden Schalters (S3) ;
einen zweiten Schalter (S2), der zwischen den Steueranschluß (210) und den ersten Anschluß (206) des zu testenden Schalters (S3) geschaltet ist, wobei der Steueranschluß (210) und der erste Anschluß (206) des zu testenden Schalters (S3) leitfähig gekoppelt sind, wenn der zweite Schalter (S2) geschlossen ist;
einer Treiberschaltung (T) mit einem Steuerausgang (212), wobei am Steuerausgang (212) eine Steuerspannung zum Steuern des zu testenden Schalters (S3) bereitstellbar ist und wobei die Treibereinrichtung (T) ausgebildet ist, um wahlweise den zu testenden Schalter (S3) ein- oder auszuschalten, wobei am Steuerausgang (212) der Treiberschaltung (T) die Steuerspannung anliegt und bei der zwischen den Steuerausgang (212) der Treibschaltung (T) und den Steueranschluß (210) des zu testenden Schalters (S3) ein dritter Schalter (S1) geschaltet ist, wobei der Steuerausgang (212) der Treiberschaltung (T) und der Steueranschluß (210) des zu testenden Schalters (S3) leitfähig verbunden sind, wenn der dritte Schalter (S1) geschlossen ist;
einer Schaltersteuereinrichtung zum Steuern des zweiten Schalters (S2) und des dritten Schalters, wobei die Schaltersteuereinrichtung ausgebildet ist, um in einem ersten Betriebsmodus den zweiten Schalter zu öffnen und den dritten Schalter zu schließen und in einem zweiten Betriebsmodus den zweiten Schalter zu schließen und den dritten Schalter zu öffnen, um im ersten oder zweiten Betriebsmodus den zu testenden Schalter (S3) auf Funktionsfähigkeit zu überprüfen; und
einer Einrichtung zum Erfassen einer aufgrund des Meßstroms vorhandenen Spannung im zweiten Betriebsmodus zwischen dem Steueranschluß (210) und dem zweiten Anschluß (208) des zu testenden Schalters (S3), wobei die Spannung auf eine Funktionsfähigkeit des zu testenden Schalters (S3) hinweist, wenn sich als Spannung eine vorbestimmte Schwellenspannung einstellt.

2. Schaltervorrichtung (100) gemäß Anspruch 1, die ferner folgendes Merkmal aufweist:
eine Einrichtung zum Erkennen des zu testenden Schalters (S3) als fehlerhaft, wobei die Einrichtung ausgebildet ist, um die Spannung zwischen dem Steueranschluß (210) und dem zweiten Anschluß (208) des zu testenden Schalters (S3) mit einer vorbestimmten Schwellenspannung zu vergleichen.

3. Schaltervorrichtung (100) gemäß Anspruch 2, bei der die Einrichtung zum Erkennen ausgebildet ist, um den zu testenden Schalter (S3) als fehlerhaft zu erkennen, wenn die Spannung kleiner als die vorbestimmte Schwellenspannung ist.

4. Schaltervorrichtung (100) gemäß Anspruch 2 oder 3, bei der der zu testende Schalter (S3) ein Transistor mit einer Transistorschwellenspannung ist, wobei die vorbestimmte Schwellenspannung gleich der Transistorschwellenspannung ist.

5. Schaltervorrichtung (100) gemäß einem der Ansprüche 1 bis 4, bei der der dritte Schalter durch einen tri-state-fähigen Steuerausgang der Treiberschaltung ausgebildet ist.

6. Schaltervorrichtung (100) gemäß einem der Ansprüche 1 bis 5, bei der die Schaltersteuereinrichtung ausgebildet ist, um in dem ersten Betriebsmodus zu sein, wenn der zu testende Schalter in einem Normalbetrieb ist, und in dem zweiten Betriebsmodus zu sein, wenn der zu testende Schalter in einem Testbetrieb ist.

7. Schaltervorrichtung (100) gemäß Anspruch 6, bei der der Testbetrieb des zu testenden Schalters (S3) dann vorliegt, wenn zwischen dem ersten Eingangsanschluß (220) und dem zweiten Eingangsanschluß (222) der Schaltervorrichtung keine Spannung anliegt.

8. Schaltervorrichtung (100) gemäß Anspruch 7, bei der die Schaltersteuereinrichtung ausgebildet ist, um in dem ersten Betriebsmodus zu sein und die ferner folgendes Merkmal aufweist:
eine In-Betrieb-Prüfeinrichtung zum Erkennen des Schalters als fehlerhaft, wobei die In-Betrieb-Prüfeinrichtung ausgebildet ist, ein Potential des ersten Anschlusses (206) des zu testenden Schalters (S3) zu erfassen und abhängig davon den zu testenden Schalter (S3) zu beurteilen.

9. Schaltervorrichtung (100) gemäß einem der Ansprüche 1 bis 8, bei der zwischen den Steueranschluß (210) und den ersten Anschluß (206) des zu testenden Schalters S3 eine Diode (D) schaltbar ist, wobei eine Kathode (K) der Diode (D) leitfähig mit dem ersten Anschluß (206) des zu testenden Schalters (S3) verbunden ist und eine Anode (A) der Diode (D) leitfähig mit dem Steueranschluß (210) des zu testenden Schalters (S3) verbindbar ist.

10. Schaltervorrichtung (100) gemäß Anspruch 9, bei der der Widerstand (R) zwischen die Anode (A) und die Einrichtung zum Bereitstellen des Meßstroms (200) geschaltet ist, wobei die Einrichtung zum Bereitstellen des Meßstroms (200) einen ersten Anschluß (202) und einen zweiten Anschluß (204) aufweist, die mit einer Spannung beaufschlagbar sind, wobei der erste Anschluß (202) mit dem Widerstand (R) verbunden ist und der zweite Anschluß (204) mit dem zweiten Anschluß (208) des zu testenden Schalters (S3) verbunden ist.

11. Ansteuerung mit folgenden Merkmalen:
einem Eingang mit einem ersten Eingangsanschluß (220) und einem zweiten Eingangsanschluß (222) zum Anlegen einer Eingangsspannung;
einem Ausgang mit einem ersten Ausgangsanschluß (230) und einem zweiten Ausgangsanschluß (232) zum Ausgeben einer Ausgangsspannung;
einer Kapazität (224), die zwischen den ersten Eingangsanschluß (220) und den zweiten Eingangsanschluß (222) geschaltet ist;
eine Diode (D1) mit einer Kathode (K1) und einer Anode (A1), wobei die Kathode (K1) leitfähig mit dem ersten Ausgangsanschluß (230) und wobei die Anode (A1) leitfähig mit dem zweiten Ausgangsanschluß (232) der Umschaltung verbunden ist;
einer ersten Schaltervorrichtung (100) gemäß Anspruch 1, wobei der erste Anschluß (206) des zu testenden Schalters (S3) mit dem ersten Eingangsanschluß (220) elektrisch leitfähig verbunden ist und wobei der zweite Anschluß (208) des zu testenden Schalters (S3) mit dem ersten Ausgangsanschluß (230) elektrisch leitfähig verbunden ist; und
einer weiteren Schaltervorrichtung (S4) mit einem ersten Anschluß (240) und einem zweiten Anschluß (242) sowie einem Steueranschluß (244), wobei der erste Anschluß (240) der weiteren Schaltervorrichtung (S4) mit dem zweiten Ausgangsanschluß (232) und der zweite Anschluß (242) der weiteren Schaltervorrichtung (S4) mit dem zweiten Eingangsanschluß (222) elektrisch leitfähig verbunden ist, wobei eine Spannung an dem Eingang auf den Ausgang der Umschaltschaltung umschaltbar ist, wenn die erste Schaltervorrichtung (S3) und die weitere Schaltervorrichtung (S4) durchgeschaltet sind.

## Claims

1. Switch device (100), comprising:
a switch (S3) to be tested with a first terminal (206) and a second terminal (208) as well as a control terminal (210) for controlling a resistance between the first terminal (206) and the second terminal (208);
a resistor (R);
a means for providing a measuring current across the resistor (R) into the first terminal (206) of the switch (S3) to be tested,
a second switch (S2) connected between the control terminal (210) and the first terminal (206) of the switch (S3) to be tested, wherein the control terminal (210) and the first terminal (206) of the switch (S3) to be tested are coupled conductively when the second switch (S2) is closed;
a drive circuit (T) with a control output (212), wherein a control voltage for controlling the switch (S3) to be tested can be provided at the control output, and wherein the drive means (T) is formed to optionally switch the switch (S3) to be tested on or off, wherein the control voltage is present at the control output (212) of the drive circuit (T), and wherein a third switch (S1) is connected between the control output (212) of the drive circuit (T) and the control terminal (210) of the switch (S3) to be tested, wherein the control output (212) of the drive circuit (T) and the control terminal (210) of the switch (S3) to be tested are conductively connected when the third switch (S1) is closed;
a switch control means for controlling the second switch (S2) and the third switch, wherein the switch control means is formed to open the second switch and close the third switch in a first mode of operation, and close the second switch and open the third switch in a second mode of operation, for testing the switch (s3) to be tested for operability in the first or second mode of operation; and
a means for sensing a voltage present due to the measuring current between the control terminal (210) and the second terminal (208) of the switch (S3) to be tested, wherein the voltage refers to an operability of the switch (S3) to be tested, when a predefined threshold voltage develops as voltage.

2. Switch device (100) of claim 1, further comprising:
a means for recognizing the switch (S3) to be tested as defective, wherein the means is formed to compare the voltage between the control terminal (210) and the second terminal (208) of the switch (S3) to be tested with a predetermined threshold voltage.

3. Switch device (100) of claim 2, wherein the means for recognizing is formed to recognize the switch (S3) to be tested as defective if the voltage is smaller than the predetermined threshold voltage.

4. Switch device (100) of claim 2 or 3, wherein the switch (S3) to be tested is a transistor with a transistor threshold voltage, wherein the predetermined threshold voltage is equal to the transistor threshold voltage.

5. Switch device (100) of one of claims 1 to 4, wherein the third switch is formed by a tristatable control output of the drive circuit.

6. Switch device (100) of one of claims 1 to 5, wherein the switch control means is formed to be in the first mode of operation when the switch to be tested is in a normal operation, and to be in the second mode of operation when the switch to be tested is in a test operation.

7. Switch device (100) of claim 6, wherein the test operation of the switch (S3) to be tested is present when no voltage is present between the first input terminal (220) and the second input terminal (222) of the switch device.

8. Switch device (100) of claim 7, wherein the switch control means is formed to be in the first mode of operation, and further comprising:
an on-the-fly testing means for recognizing the switch as defective, wherein the on-the-fly testing means is formed to detect a potential of the first terminal (206) of the switch (S3) to be tested and assess the switch (S3) to be tested in dependence thereof.

9. Switch device (100) of one of claims 1 to 8, wherein a diode (D) can be connected between the control terminal (210) and the first terminal (206) of the switch (S3) to be tested, wherein a cathode (K) of the diode (D) is conductively connected to the first terminal (206) of the switch (S3) to be tested and an anode (A) of the diode (D) can be conductively connected to the control terminal (210) of the switch (S3) to be tested.

10. Switch device (100) of claim 9, wherein the resistor (R) is connected between the anode (A) and the means for providing the measuring current (200), wherein the means for providing the measuring current (200) comprises a first terminal (202) and a second terminal (204), to which a voltage can be applied, wherein the first terminal (202) is connected to the resistor (R) and the second terminal (204) is connected to the second terminal (208) of the switch (S3) to be tested.

11. Controller, comprising:
an input with a first input terminal (220) and a second input terminal (222) for applying an input voltage;
an output with a first output terminal (230) and a second output terminal (232) for outputting an output voltage;
a capacitor (224) connected between the first input terminal (220) and the second input terminal (222);
a diode (D1) with a cathode (K1) and an anode (A1), wherein the cathode (K1) is conductively connected to the first output terminal (230), and wherein the anode (A1) is conductively connected to the second output terminal (232) of the switching circuit;
a first switch device (100) of claim 1, wherein the first terminal (206) of the switch (S3) to be tested is connected to the first input terminal (220) in electrically conductive manner, and wherein the second terminal (208) of the switch (S3) to be tested is connected to the first output terminal (230) in electrically conductive manner; and
a further switch device (S4) with a first terminal (240) and a second terminal (242) as well as a control terminal (244), wherein the first terminal (240) of the further switch device (S4) is connected to the second output terminal (232) and the second terminal (242) of the further switch device (S4) to the second input terminal (222) in electrically conductive manner, wherein a voltage at the input can be switched to the output of the switching circuit when the first switch device (S3) and the further switch device (S4) are connected through.

## Revendications

1. Système à commutateur (100) aux caractéristiques suivantes :
un commutateur à tester (S3) avec une première connexion (206) et une deuxième connexion (208) ainsi qu'une connexion de commande (210) pour régler une résistance entre la première connexion (206) et la deuxième connexion (208) ;
une résistance (R) ;
un dispositif destiné à mettre à disposition un courant de mesure par l'intermédiaire de la résistance (R) dans la première connexion (206) du commutateur à tester (S3) ;
un deuxième commutateur (S2) qui est connecté entre la connexion de commande (210) et la première connexion (206) du commutateur à tester (S3), la connexion de commande (210) et la première connexion (206) du commutateur à tester (S3) étant couplées de manière électriquement conductrice lorsque le deuxième commutateur (S2) et fermé ;
un circuit pilote (T) avec une sortie de commande (212), à la sortie de commande (212) pouvant être mise à disposition une tension de commande pour commander le commutateur à tester (S3) et le dispositif pilote (T) étant réalisé de manière à enclencher ou déclencher alternativement le commutateur à tester (S3), à la sortie de commande (212) du circuit pilote (T) étant présente la tension de commande et dans lequel étant connecté, entre la sortie de commande (212) du circuit pilote (T) et la connexion de commande (210) du commutateur à tester (S3), un troisième commutateur (S1), la sortie de commande (212) du circuit pilote (T) et la connexion de commande (210) du commutateur à tester (S3) étant reliées de manière conductrice lorsque le troisième commutateur (S1) est fermé ;
un dispositif de commande de commutateur destiné à commander le deuxième commutateur (S2) et le troisième commutateur, le dispositif de commande de commutateur étant réalisé de manière, dans un premier mode de fonctionnement, à ouvrir le deuxième commutateur et fermer le troisième commutateur et, dans un deuxième mode de fonctionnement, à fermer le deuxième commutateur et fermer le troisième commutateur, pour contrôler, dans le premier ou le deuxième mode de fonctionnement, le commutateur à tester (S3) quant à l'aptitude à fonctionner ; et
un dispositif destiné à capter une tension présente sur base du courant de mesure dans le deuxième mode de fonctionnement entre la connexion de commande (210) et la deuxième connexion (208) du commutateur à tester (S3), la tension indiquant une aptitude à fonctionner du commutateur à tester (S3) lorsqu'il est établi comme tension une tension de seuil prédéterminée.

2. Système à commutateur (100) selon la revendication 1, présentant, par ailleurs, la caractéristique suivante :
un dispositif destiné à identifier le commutateur à tester (S3) comme étant défectueux, le dispositif étant réalisé de manière à comparer la tension entre la connexion de commande (210) et la deuxième connexion (208) du commutateur à tester (S3) avec une tension de seuil prédéterminée.

3. Système à commutateur (100) selon la revendication 2, dans lequel le dispositif destiné à identifier est réalisé de manière à identifier le commutateur à tester (S3) comme étant défectueux lorsque la tension est inférieure à la tension de seuil prédéterminée.

4. Système à commutateur (100) selon la revendication 2 ou 3, dans lequel le commutateur à tester (S3) est un transistor avec une tension de seuil de transistor, la tension de seuil prédéterminée étant égale à la tension de seuil du transistor.

5. Système à commutateur (100) selon l'une des revendications 1 à 4, dans lequel le troisième commutateur est réalisé par une sortie de commande permettant trois états du circuit pilote.

6. Système à commutateur (100) selon l'une des revendications 1 à 5, dans lequel le dispositif de commande de commutateur est réalisé de manière à être dans le premier mode de fonctionnement lorsque le commutateur à tester est en fonctionnement normal et à être dans le deuxième mode de fonctionnement lorsque le commutateur à tester est en fonctionnement de test.

7. Système à commutateur (100) selon la revendication 6, dans lequel le fonctionnement de test du commutateur à tester (S3) est présent lorsqu'il n'est pas présent de tension entre la première connexion d'entrée (220) et la deuxième connexion d'entrée (222) du système à commutateur.

8. Système à commutateur (100) selon la revendication 7, dans lequel le dispositif de commande de commutateur est réalisé de manière à être dans le premier mode de fonctionnement et présentant, par ailleurs, la caractéristique suivante :
un dispositif de vérification en fonctionnement destiné à identifier le commutateur comme étant défectueux, le dispositif de vérification en fonctionnement étant réalisé de manière à capter un potentiel de la première connexion (206) du commutateur à tester (S3) et à juger le commutateur à tester (S3) en fonction de ce dernier.

9. Système à commutateur (100) selon l'une des revendications 1 à 8, dans lequel une diode (D) peut être connectée entre la connexion de commande (210) et la première connexion (206) du commutateur à tester (S3), une cathode (K) de la diode (D) étant reliée de manière conductrice à la première connexion (206) du commutateur à tester (S3) et une anode (A) de la diode (D) peut être connectée de manière conductrice à la connexion de commande (210) du commutateur à tester (S3).

10. Système à commutateur (100) selon la revendication 9, dans laquelle la résistance (R) est connectée entre l'anode (A) et le dispositif destiné à mettre à disposition le courant de mesure (200), le dispositif destiné à mettre à disposition le courant de mesure [200] présentant une première connexion (202) et une deuxième connexion (204) qui peuvent être soumises à une tension, la première connexion (202) étant reliée à la résistance (R) et la deuxième connexion (204) étant reliée à la deuxième connexion (208) du commutateur à tester (S3).

11. Dispositif d'activation, aux caractéristiques suivantes :
une entrée avec une première connexion d'entrée (220) et une deuxième connexion d'entrée (222) pour appliquer une tension d'entrée;
une sortie avec une première connexion de sortie (230) et une deuxième connexion de sortie (232) pour sortir une tension de sortie ;
une capacité (224) qui est connectée entre la première connexion d'entrée (220) et la deuxième connexion d'entrée (222) ;
une diode (D1) avec une cathode (K1) et une anode (A1), la cathode (K1) étant reliée de manière conductrice à la première connexion de sortie (230) et l'anode (A1) étant reliée de manière conductrice à la deuxième connexion de sortie (232) de la commutation;
un premier système à commutateur (100) selon la revendication 1, dans lequel la première connexion (206) du commutateur à tester (S3) est reliée de manière électriquement conductrice à la première connexion d'entrée (220) et la deuxième connexion (208) du commutateur à tester (S3) est reliée de manière électriquement conductrice à la première connexion de sortie (230) ; et
un autre système à commutateur (S4) avec une première connexion (240) et une deuxième connexion (242) ainsi qu'une connexion de commande (244), la première connexion (240) de l'autre système à commutateur (S4) étant reliée de manière électriquement conductrice à la deuxième connexion de sortie (232) et la deuxième connexion (242) de l'autre système à commutateur (234) étant reliée de manière électriquement conductrice à la deuxième connexion d'entrée (222), une tension à l'entrée pouvant être commutée à la sortie du circuit de commutation lorsque le premier système à commutateur (S3) et l'autre système à commutateur (S4) sont connectés.
